Europäisches Patentamt

European Patent Office

Office européen des brevets

(19)

(11) **EP 0 917 294 B1**

(12) **FASCICULE DE BREVET EUROPEEN**

(45) Date de publication et mention
de la délivrance du brevet:
**21.04.2004 Bulletin 2004/17**

(51) Int Cl.⁷: **H03M 13/00**

(21) Numéro de dépôt: **98203785.5**

(22) Date de dépôt: **10.11.1998**

(54) **Système de transmission numérique, décodeur, et procédé de décodage**

Digitales Übertragungssystem, Dekoder und Dekodierungsverfahren

Digital transmission system, decoder, and decoding method

(84) Etats contractants désignés:
**BE DE ES FR GB IT LU**

(30) Priorité: **18.11.1997 FR 9714451**

(43) Date de publication de la demande:
**19.05.1999 Bulletin 1999/20**

(73) Titulaire: **Koninklijke Philips Electronics N.V.**
**5621 BA Eindhoven (NL)**

(72) Inventeurs:
• **Chouly, Antoine**
**75008 Paris (FR)**
• **Brajal, Américo**
**75008 Paris (FR)**

(74) Mandataire: **Landousy, Christian**
**Société Civile SPID,**
**156, Boulevard Haussmann**
**75008 Paris (FR)**

(56) Documents cités:
**EP-A- 0 755 122**    **WO-A-97/40582**
**US-A- 5 563 897**

• **LI PING, CHAN & YEUNG: "efficient soft in soft out suboptimal decoding rule for single parity check codes" ELECTRONIC LETTERS, vol. 33, no. 19, 11 septembre 1997, pages 1614-1616, XP002078353**
• **BERROU C. ET AL: 'Les turbo-codes: une nouvelle approche du codage' REE, REVUE GENERALE D'ELECTRICITE ET D'ELECTRONIQUE no. 1, Janvier 1997, pages 68 - 74**
• **BLAZEK Z. ET AL: 'A DSP-BASED IMPLEMENTATION OF A TURBO-DECODER' PROCEEDINGS OF THE IEEE GLOBAL TELECOMMUNICATIONS CONFERENCE GLOBECOM'98 vol. 5, 08 Novembre 1998 - 12 Novembre 1998, SYDNEY, pages 2751 - 2755**

**Description**

L'invention concerne un système de transmission numérique comportant en émission des moyens de codage de données à transmettre, et en réception des moyens de décodage itératif des données reçues, lesdits moyens de décodage itératif utilisant les données reçues comme grandeurs d'entrée initiales, et comportant des moyens de calcul d'informations de fiabilité relatives à des décisions douces à partir de grandeurs d'entrée, à chaque itération, et des moyens pour réinjecter des grandeurs d'entrée subséquentes pour l'itération suivante.

L'invention concerne également un procédé de décodage et un décodeur.

L'invention a d'importantes applications pour les systèmes de transmission de petits paquets de données sur un canal de puissance limitée, par exemple pour les systèmes interactifs bidirectionnels de transmission par satellite. Dans de tels systèmes interactifs, une voie de retour est prévue pour permettre aux abonnés d'interagir avec les informations qui leur sont envoyées. La capacité de cette voie de retour est partagée entre les abonnés en utilisant un mécanisme de réservation. Ce mécanisme de réservation consiste à émettre des requêtes pour se faire attribuer des créneaux temporels dans une trame montante suivante. Les données transmises sont donc constituées de séquences de petits paquets de requête ou d'informations qui sont émis par différents abonnés, ce qui implique de coder indépendamment chaque paquet. De plus, l'abonné étant équipé d'une petite antenne, le canal montant est limité en puissance. De tels systèmes nécessitent donc l'utilisation d'une méthode de codage/décodage très puissante (pour ce type d'application il est nécessaire d'avoir un taux d'erreur paquet inférieur à $10^{-5}$).

Une méthode de décodage itératif pour des codes multidimensionnels à parité simple est décrite dans l'article intitulé "Efficient soft-in-soft-out sub-optimal decoding rule for single parity check codes" publié dans la revue ELECTRONICS LETTERS du 11 Septembre 1997 (Vol.33, N°19).

Une méthode de décodage itératif pour des codes produits est décrite dans l'article suivant : "Les turbo-codes : une nouvelle approche du codage", Claude Berrou, Ramesh Pyndiah, et Alain Glavieux, Revue générale d'Electricité et d'Electronique, janvier 1997, pges 68-74.

Cet article décrit qu'il faut augmenter la valeur d'un coefficient de prise en compte de l'information extrinsèque au cours des itérations car la fiabilité de l'information extrinsèque croît au cours des itérations.

En outre, une méthode de décodage itératif utilisant comme code de base un décodeur de Viterbi à décision douces (SOVA) est décrite dans l'article suivant: "a dsp-based implementation of a turbo-decoder", z. Blazek et v. Bhargava, proceedings of the IEEE global telecommunications conference GLOBECOM'98 in Sydney, 08-12 Novembre 1998, vol. 5, pages 2751 à 2755. Cet article décrit quatre méthodes de normalisation de l'information extrinsèque. La seconde méthode décrite utilise une normalisation par le coefficient multiplicatif $c = m_z \cdot 2/\sigma_z^2$, dans lequel $m_z$ et $\sigma_z^2$ représentent la moyenne et la variance de la valeur absolue de l'information extrinsèque.

L'invention a notamment pour but de proposer une solution qui permette d'améliorer les performances obtenues.

Pour cela, un système de transmission selon l'invention est caractérisé en ce que lesdits moyens de décodage comportent :

- des moyens de calcul à l'itération j d'une valeur moyenne de plusieurs décisions douces obtenues au cours de l'itération j,
- des moyens de transformation pour calculer des informations transformées à partir desdites décisions douces, lesdites informations transformées étant obtenues en divisant lesdites décisions douces par ladite valeur moyenne,
- et des moyens d'élaboration des grandeurs d'entrée subséquentes à partir desdites informations transformées.

L'invention permet ainsi de tenir compte du fait que les informations de fiabilité sont théoriquement réparties selon une distribution gaussienne autour de la valeur +1.

Dans un autre mode de réalisation avantageux d'un système de transmission selon l'invention, lesdits moyens de décodage comportent des moyens de pondération pour calculer des sommes pondérées d'une fonction desdites décisions douces et des grandeurs d'entrée initiales, avec un premier et un second coefficient de pondération respectivement, et des moyens d'élaboration des grandeurs d'entrée subséquentes à partir desdites sommes pondérées.

Une telle pondération permet d'éviter la propagation de mauvaises décisions prises au début du processus itératif de décodage. Lorsque ladite fonction est choisie de façon à fournir les informations transformées à partir des décisions douces, on combine les avantages des deux modes de réalisation qui viennent d'être exposés.

De même un procédé de décodage de données selon l'invention, utilisant lesdites données comme grandeurs d'entrée initiales, est caractérisé en ce qu'il comporte:

- une étape de calcul à l'itération j d'une valeur moyenne de plusieurs décisions douces obtenues au cours de l'itération j,
- une étape de transformation pour calculer des informations transformées à partir desdites décisions douces, lesdites informations transformées étant obtenues en divisant lesdites décisions douces par ladite valeur moyenne,

- et une étape d'élaboration des grandeurs d'entrée subséquentes à partir desdites informations transformées.

Enfin, un décodeur selon l'invention, doté de moyens de décodage itératif de données qui utilisent lesdites données comme grandeurs d'entrée initiales, est caractérisé en ce que lesdits moyens de décodage comportent:

- des moyens de calcul à l'itération j d'une valeur moyenne de plusieurs décisions douces obtenues au cours de l'itération j,
- des moyens de transformation pour calculer des informations transformées à partir desdites décisions douces, lesdites informations transformées étant obtenues en divisant lesdites décisions douces par ladite valeur moyenne,
- et des moyens d'élaboration des grandeurs d'entrée subséquentes à partir desdites informations transformées.

L'invention sera mieux comprise et d'autres détails apparaîtront dans la description qui va suivre en regard des dessins annexés qui sont donnés à titre d'exemples non limitatifs et dans lesquels:

- la figure 1 est un schéma d'un exemple de système de transmission numérique selon l'invention,
- la figure 2 est un schéma explicatif d'un principe d'affectation de données codées à une constellation,
- la figure 3 est un diagramme résumant les principales étapes d'un procédé de décodage itératif selon l'invention,
- la figure 4 est un schéma d'un décodeur itératif selon l'invention,
- les figures 5A et 5B sont des diagrammes représentant les résultats obtenus avec un système selon l'invention avant et après le décodage de Reed Solomon respectivement,
- les figures 6A et 6B sont des courbes représentant la densité de probabilité des grandeurs d'entrée pour la première et la quatrième itération respectivement.

L'invention va maintenant être décrite pour des applications de transmission de données. Ceci n'est pas limitatif. Par exemple elle peut également être utilisée pour des applications de récupération de données stockées sur disque.

Dans la suite de la description, on utilise des techniques connues de contrôle d'erreurs dans les transmissions numériques. Pour plus de détails sur ces techniques, on peut par exemple se référer à l'ouvrage de Arnold M. Michelson et Allen H. Levesque intitulé "Error control techniques for digital communications" publié aux éditions Wiley Intersciences en 1985.

Dans la suite de la description, l'expression "code produit" ou "code multidimensionnel" désigne un code qui peut être représenté par une matrice à plusieurs dimensions dont chaque dimension donne un mot de code, des codes et des tailles de mots de code différents pouvant être utilisés pour chaque dimension.

On va maintenant décrire un exemple de système de transmission numérique selon l'invention dont les performances sont suffisantes pour des applications de transmission montante par satellite évoquées plus haut. Cet exemple n'est pas limitatif.

En particulier (et comme cela est exposé en détails dans la suite de la description), afin d'améliorer les performances du système, on concatène un code de Reed Solomon et un code produit à parités entrelacées à deux dimensions (chaque ligne et chaque colonne de la matrice constituent un mot de code, et le code utilisé est un code de parité pour chacune des deux dimensions). Mais l'invention est applicable à tout type de code susceptible d'être décodé par décodage itératif, notamment à tout type de code utilisant un code produit.

De même, on utilise une constellation à quatre états QPSK (de l'anglais Quadrature Phase Shift Keying) de telle sorte que le décodage consiste à prendre des décisions entre deux valeurs possibles (ici entre -1 et +1) pour chaque symbole reçu sur les voies en phase et en quadrature. On pourrait utiliser une constellation d'un autre type, par exemple une constellation OQPSK (de l'anglais Offset Quadrature Phase Shift Keying dans laquelle on introduit un décalage d'un demi symbole entre les deux voies). On peut également utiliser une constellation d'une autre taille, par exemple une constellation BPSK à deux états (de l'anglais Binary Phase Shift Keying), ou une constellation de taille supérieure. Avec une constellation de taille supérieure, on peut par exemple se ramener à des décisions à prendre du même type en utilisant des techniques connues de codage multi-niveaux, ou l'on peut adapter la méthode de décodage itératif classique au nouveau type de décisions à prendre.

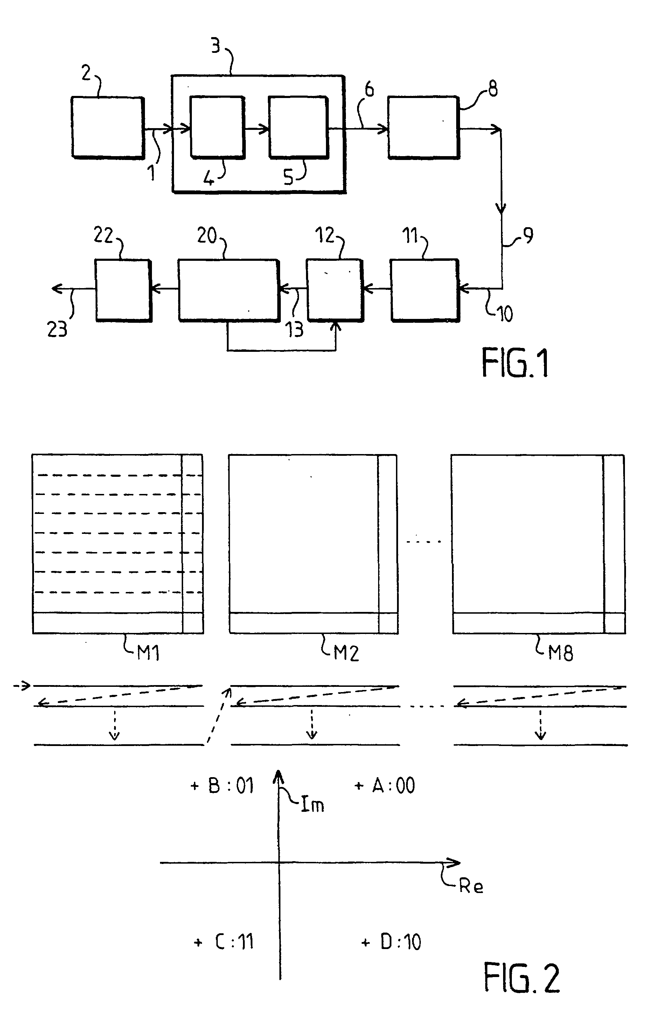

Sur la figure 1 on a représenté un schéma d'un tel système de transmission numérique. En émission, les données à transmettre 1, issues d'une source 2, sont fournies à des moyens de codage 3. Ces moyens de codage sont constitués par des premiers moyens de codage de Reed Solomon 4 mis en cascade avec des seconds moyens de codage multidimensionnel à parités entrelacées 5. Les données codées 6 délivrées en sortie des moyens de codage 3 sont affectées à des symboles d'une constellation par des moyens de modulation 8. Ces symboles sont transmis à travers un canal 9.

En réception, les données reçues 10 sont traitées par des moyens habituels de démodulation 11 puis stockées dans une mémoire 12 sous forme d'une première matrice. Ces données reçues constituent des grandeurs d'entrée initiales, c'est-à-dire qu'elles servent de grandeurs d'entrée 13 pour des moyens de décodage itératif 20 pour la première itération. Les données délivrées en sortie des moyens de décodage itératif sont regroupées dans une deuxième matrice stockée dans la mémoire 12 et servent de grandeurs d'entrée subséquentes 13 pour l'itération suivante. Les moyens de décodage itératif 20 sont montés en cascade avec des moyens classiques de décodage de Reed Solomon 22 qui délivrent des décisions finales 23 sur les données codées reçues.

A titre d'exemple, on utilise pour le codage le code de Reed Solomon dont le polynôme générateur est

$$\prod_{i=1}^{2t} (x + \alpha^i)$$

où $\alpha$ est racine de $x^8 \oplus x^4 \oplus x^3 \oplus x^2 \oplus 1$, polynôme engendrant le corps de Galois à 256 éléments $GF(2^8)$, et t est le nombre d'octets que le code est capable de corriger. Dans l'exemple décrit ici, on choisit t=5. Ainsi, si l'on émet des paquets de données de 54 octets (cellule ATM plus octet réservé), on obtient des paquets de 64 octets en sortie des moyens 4 de codage de Reed Solomon.

Les moyens 5 de codage multidimensionnel à parités entrelacées ajoutent un bit de parité à chacun des octets délivrés en sortie des moyens 4 de codage de Reed Solomon, puis regroupent 8 mots de 9 bits ainsi obtenus pour former une matrice 8x9. Un bit de parité est ensuite ajouté à chaque colonne de la matrice de façon à former une neuvième ligne. La matrice qui en résulte est une matrice 9x9. Ainsi, en reprenant l'exemple précédent, à partir des 64 octets délivrés en sortie des moyens 4 de codage de Reed Solomon, on obtient 8 matrices 9x9 (notées M1 à M8) en sortie des moyens 5 de codage multidimensionnel à parités entrelacées.

Ces 8 matrices sont parcourues comme indiqué sur la figure 2 par les moyens d'affectation 7 qui affectent à chaque couple de bits un point d'une constellation QPSK. Lorsque le canal 9 est un canal de puissance limitée il est avantageux d'utiliser un codage différentiel. Dans ce cas on applique par exemple la règle d'affectation suivante entre deux symboles consécutifs:

- 00: pas de changement de phase,
- 01: +90°,
- 11: +180°,
- 10: -90°.

Le principe du décodage itératif (ou décodage turbo) a été exposé dans la conférence "Near Shannon error correcting coding and decoding: turbo codes" de A. Glavieux et al, IEEE ICC-93, pages 1064-1071, en mai 1993. Il consiste à se rapprocher d'un décodage optimal en effectuant N itérations d'un décodage non optimal. Les N-1ème premières itérations consistent à élaborer une décision douce égale au produit d'une information de fiabilité sur un symbole reçu et de la décision, dite décision dure, prise sur ce symbole, et à réinjecter cette décision douce en entrée des moyens de décodage pour l'itération suivante. La dernière itération délivre une décision dure.

Dans l'exemple qui est décrit ici, ce décodage itératif permet de prendre des décisions binaires sur des symboles réels reçus, sachant que chaque élément d'un mot de code a une valeur dans l'ensemble {-1; +1}, et consiste à alterner un décodage par ligne et un décodage par colonne de la matrice des grandeurs d'entrée $(r_{i,j})$, plusieurs fois. Chaque décodage par ligne ou par colonne constitue une itération du décodage. Dans la suite on note N le nombre d'itérations nécessaires pour converger vers un décodage optimal. Les grandeurs d'entrée initiales utilisées pour la première itération sont constituées par les symboles réels reçus. Les N-1 premières itérations permettent de calculer, pour chaque élément $r_{i,j}$ de chaque ligne ou colonne, une information de fiabilité $f_{i,j}$ et une décision douce $r'_{i,j}$ puis, conformément à l'invention, une grandeur $r''_{i,j}$ déduite de cette décision douce. Les grandeurs $r''_{i,j}$ calculées pour une itération j sont stockées dans la mémoire 12 et utilisées comme grandeurs d'entrée subséquente $r_{i,j+1}$ par les moyens 20 de décodage itératif pour l'itération j+1. La dernière itération consiste à décoder d'une façon optimale le bloc $r_{i,N}$ (i=1,0...,n), sans calculer les fiabilités des symboles $r_{i,N}$.

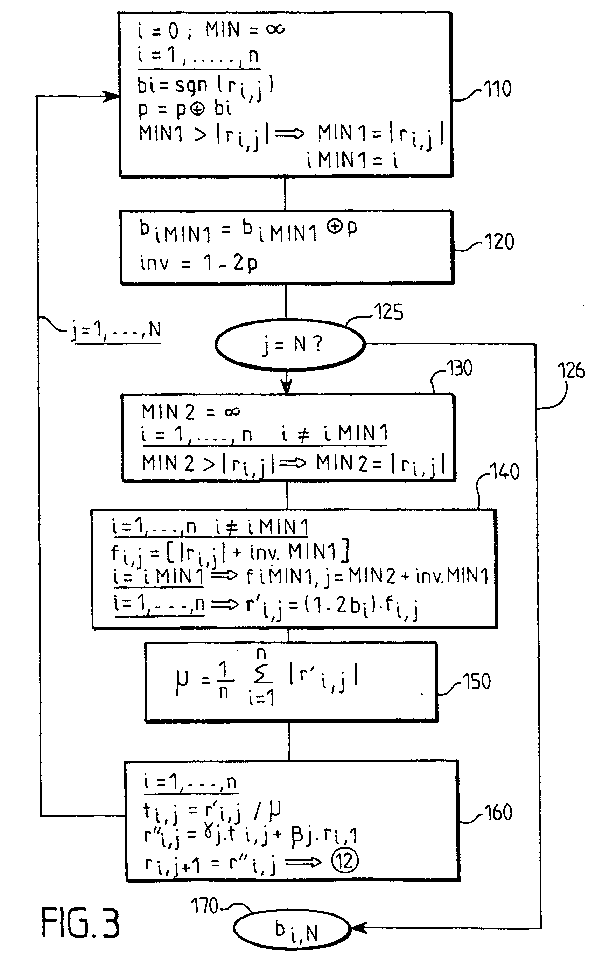

Comme cela est résumé sur la figure 3, un procédé de décodage itératif selon l'invention comporte les étapes suivantes, pour chaque itération et pour chaque ligne ou colonne $(r_{l,j}, ..., (r_{i,j}, ...,r_{n,j})$:

- première étape 110: calcul de la parité p de la ligne ou de la colonne et recherche du symbole $r_{i,j}$ le moins fiable c'est-à-dire le plus proche de zéro (ce symbole est appelé premier minimum et noté MIN1):
  initialisation: p=0 et MIN1 = $\infty$,
  pour i variant de 1 à n,
  　calcul de $b_i$=sgn($r_{i,j}$), avec sgn(x)=0 si x>0 et 1 sinon
  　calcul de p = p $\oplus$ $b_i$
  　si MIN1>|$r_{i,j}$| alors MIN1=|$r_{i,j}$| et iMIN1=i
- seconde étape 120: correction du symbole le moins fiable, et calcul d'un indicateur de signe noté inv:
  $b_{iMIN1}$ = $b_{iMIN1}$ $\oplus$ p
  inv = 1-2p
- troisième étape 125: test j=N?
  Si j=N, le décodage est terminé ce qui est symbolisé sur la figure 3 par une flèche 126 vers une case 170 de fin du procédé. Les décisions dures sont constituées par le bloc $b_i$ (i=0,...,n). Si j≠N l'itération se poursuit avec les étapes suivante 130 à 160.
- quatrième étape 130: recherche du second minimum noté MIN2: initialisation: MIN2 = $\infty$,
  pour i variant de 1 à n et i≠iMIN1,

si MIN2>$|r_{i,j}|$, alors MIN2=$|r_{i,j}|$

- cinquième étape 140: calcul de la fiabilité $f_{i,j}$ et de la décision douce $r'_{i,j}$:

$$f_{i,j} = \left[ \left| r_{i,j} \right| + \text{inv.MIN1} \right]$$

pour i variant de 1 à n et i≠iMIN1,
pour i=iMIN1, $f_{iMIN1,j}$ = MIN2+inv.MIN1
et pour tout i variant de 1 à n, $r'_{i,j}=(1-2b_i).f_{i,j}$
(ce calcul de fiabilité est un calcul classique dont le principe est par exemple rappelé dans l'article "Efficient soft-in-soft-out sub-optimal decoding rule for single parity check codes" qui a été cité dans les paragraphes introductifs.)

- sixième étape 150: calcul de la valeur moyenne μ des décisions douces sur la ligne ou sur la colonne:

$$\mu = \frac{1}{n} \sum_{i=1}^{n} \left| r_{i,j} \right|$$

On notera que dans le cas où la matrice est petite, il est avantageux de calculer la moyenne μ sur toute la matrice et non pas seulement sur une ligne ou une colonne.

- septième étape 160: calcul des informations transformées $t_{i,j}$, des sommes pondérées $r''_{i,j}$, et stockage des grandeurs d'entrée subséquentes $r_{i,j+1}=r''_{i,j}$ dans la mémoire 12:

pour i variant de 1 à n,
calcul de $t_{i,j} = r'_{i,j} / \mu$
calcul de $r''_{i,j}=\gamma_j.t_{i,j}+\beta_j.r_{i,1}$

où $\gamma_j$ et $\beta_j$ sont les premier et second coefficients de pondération, et $r_{i,1}$ sont les grandeurs d'entrées initiales qui correspondent à cette ligne ou cette colonne. De façon avantageuse on choisit $\beta_j=1-\gamma_j$, et $\gamma_1 = 0.5$, $\gamma_2 = 0.8$ et $\gamma_{1\neq 1,2} = 1$. Ainsi, en diminuant le poids des grandeurs d'entrée initiales au fur et à mesure des itérations, on tient compte du fait que le risque de divergence diminue avec le nombre d'itérations, tandis que la correction de l'erreur augmente.

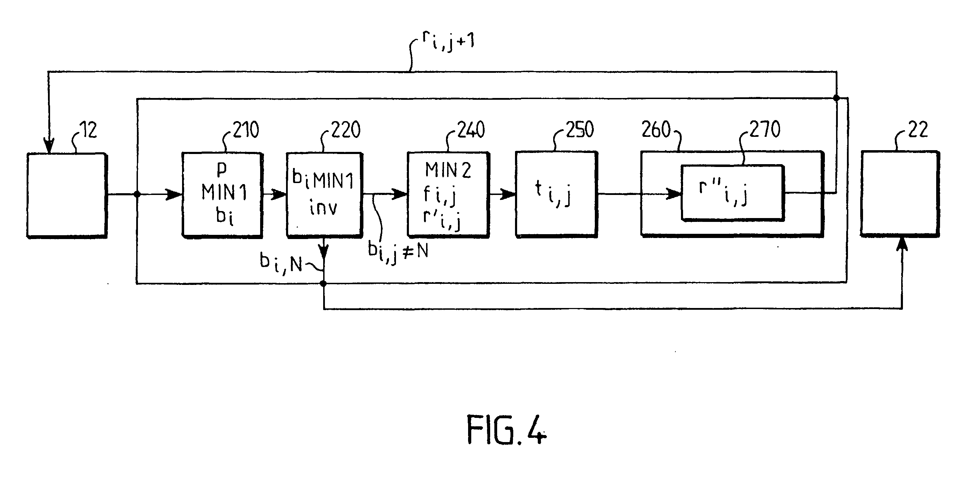

Sur la figure 4, on a représenté un schéma détaillé des moyens 20 de décodage itératif. Les moyens 20 de décodage itératif comportent:

- des moyens 210 de correction de parité, de recherche du premier minimum parmi chaque ligne ou chaque colonne traitée, et d'élaboration des décisions dures $b_i$,
- des moyens 220 de correction de la décision dure relative au symbole le moins fiable ($b_{iMIN1} = b_{iMIN1} \oplus p$), et de calcul d'un indicateur de signe inv=1-2p. Les décisions dures $b_{i,j\neq N}$ sont transmises aux moyens 240. Les décisions dures $b_{i,N}$ sont transmises aux moyens 22 de décodage de Reed Solomon.

- des moyens 240 de calcul des informations de fiabilité $f_{i,j}$ et des décisions douces $r'_{i,j}$,
- des moyens de transformation 250 pour calculer les informations transformées $t_{i,j}$ à partir des décisions douces $r'_{i,j}$, de façon à normaliser la valeur moyenne des informations de fiabilité $f_{i,j}$,
- des moyens 260 d'élaboration des grandeurs d'entrée subséquentes à réinjecter à partir desdites informations transformées $t_{i,j}$, ces moyens 260 étant constitués dans l'exemple de réalisation qui est décrit ici par des moyens 270 de pondération pour calculer des sommes pondérées $r''_{i,j}$ desdites informations transformées $t_{i,j}$ et des grandeurs d'entrées initiales $r_{i,1}$, avec un premier et un second coefficient de pondération $\gamma_j$ et $\beta_j$ respectivement. Ces sommes pondérées $r''_{i,j}$ sont stockées dans la mémoire 12 afin d'être fournies comme grandeurs d'entrée subséquente $r_{i,j+1}$ aux moyens 20 de décodage itératif pour l'itération suivante j+1.

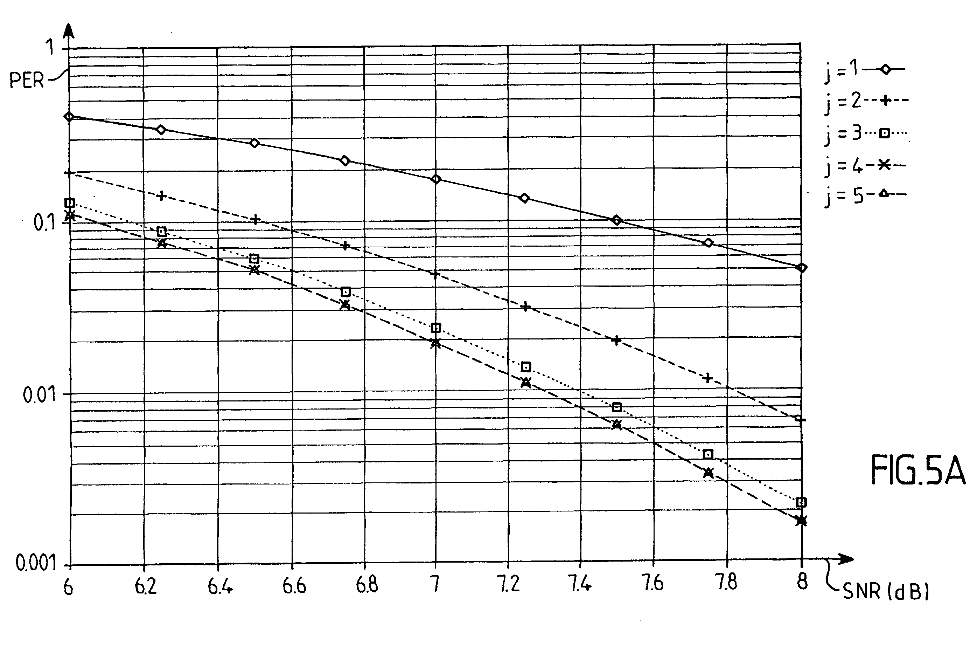

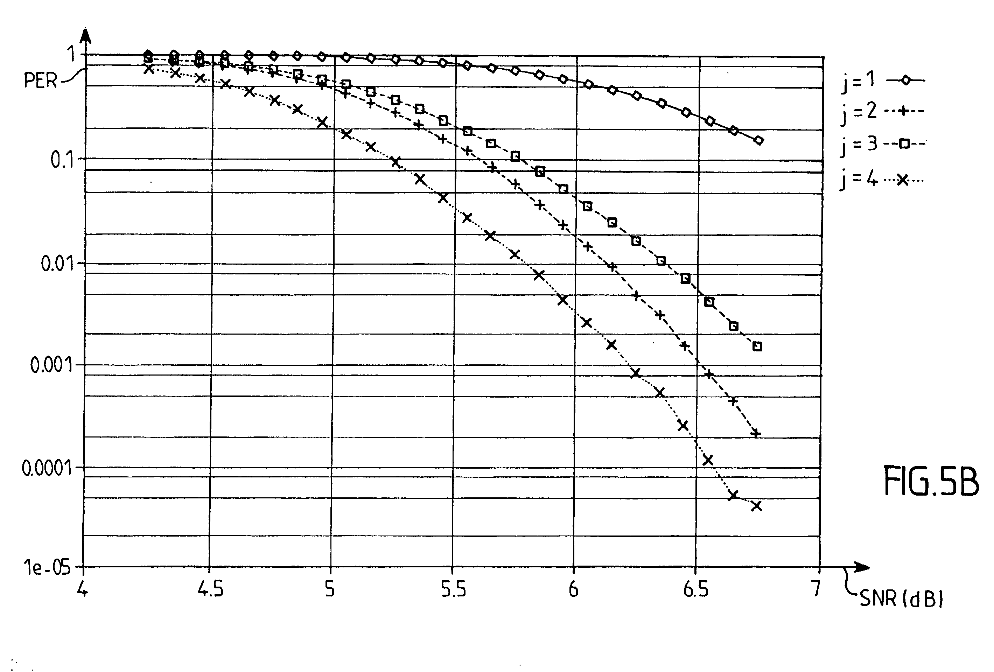

Sur les figures 5A et 5B, on a représenté l'évolution du taux d'erreur paquet PER en fonction du rapport signal à bruit SNR exprimé en dB, au fur et à mesure des itérations, avant le décodage Reed Solomon et après le décodage Reed Solomon respectivement, avec le décodeur qui vient d'être décrit. La figure 5A montre que l'on est très proche du décodage optimal à la troisième itération. Les résultats de la figure 5B ont été obtenus avec une première itération correspondant à un décodage par colonne. Or dans l'exemple qui a été décrit ce sont les lignes de la matrice qui correspondent au mot de code de Reed Solomon. Par conséquent, ce sont les itérations paires qui correspondent à un décodage dans le sens des mots de code de Reed Solomon. Le code de parité ayant tendance a regrouper les erreurs dans le sens du décodage, et le code de Reed Solomon étant adapté à la correction de paquets d'erreurs, les performances, après décodage de Reed Solomon, sont donc supérieures pour les itérations paires. Ces figures permettent de conclure qu'on obtiendra des performances optimales (pour un coût en calcul minimal) en effectuant 3 itérations, dans l'ordre ligne-colonne-ligne.

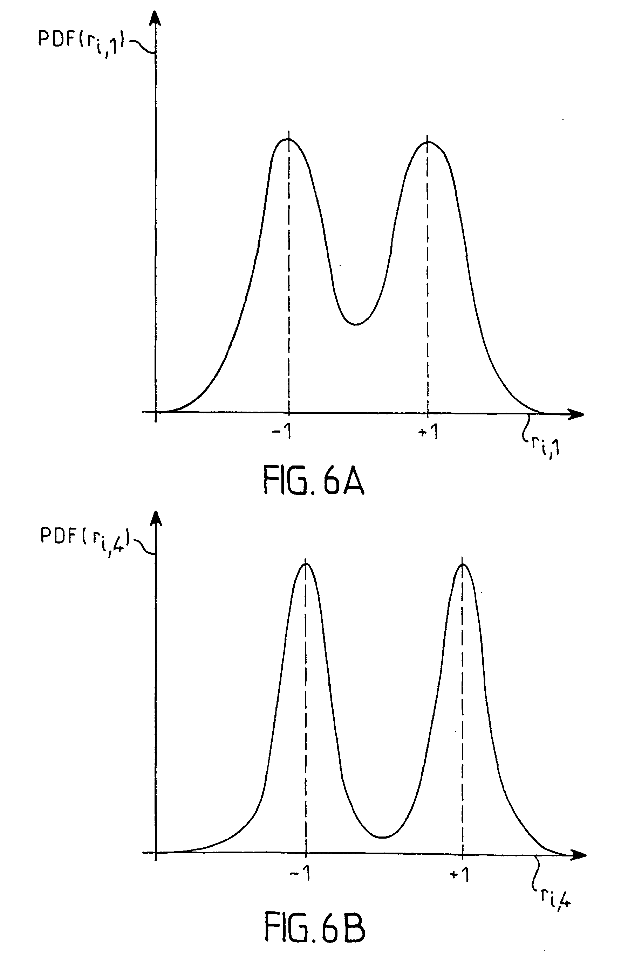

Sur les figures 6A et 6B on a donné une autre représentation des résultats obtenus avec le décodeur qui vient d'être décrit. Ces figures donnent respectivement la densité de probabilité PDF($r_{i,j}$) des grandeurs d'entrée initiales $r_{i,j}$ fournies en entrée du décodeur avant la première itération ($r_{i,1}$) et les grandeurs d'entrée subséquentes fournies en entrée du décodeur après la troisième itération ($r_{i,4}$). On constate que l'on s'est rapproché d'une courbe idéale (taux d'erreur nul) composée de deux enveloppes distinctes autour des valeurs -1 et +1: l'enveloppe s'est affinée autour des valeurs -1 et +1, la densité de probabilité des valeurs -1 et +1 a augmenté, et la zone d'intersection est beaucoup plus réduite.

L'invention n'est pas limitée au mode de réalisation préférentiel qui vient d'être décrit en référence aux figures 3 et 4.

Dans une première variante de ce mode de réalisation, on choisit $\gamma_j$=1 pour tout j, ce qui entraîne un dégradation de 0.1 à 0.2 dB du rapport signal à bruit SNR.

Dans une seconde variante, on remplace la valeur moyenne $\mu$ par un nombre constant K qui dépend du rapport signal à bruit. Ceci entraîne également une dégradation de 0.1 à 0.2 dB du rapport signal à bruit SNR.

Dans une troisième variante on supprime la recherche du second minimum, et on utilise l'expression suivante pour le calcul de la fiabilité lorsque i=iMIN1:

$$f_{iMIN1,j}=(1+inv).MIN1+\Delta$$

où $\Delta$ est un nombre constant qui dépend du rapport signal à bruit du signal (des simulations ont montré qu'une dégradation de l'ordre de 0.1dB pouvait en résulter pour $\Delta$=0.1).

Dans un autre mode de réalisation, la fonction $t_{i,j}$ des décisions douces $r'_{i,j}$ est remplacée par une autre fonction que celle qui a été décrite ($t_{i,j} = r'_{i,j} / \mu$ avec

$$\mu = \frac{1}{n} \sum_{i=1}^{n} \left| r_{i,j} \right| ),$$

par exemple par la fonction identité, ce qui revient à se limiter à une opération de pondération entre la décision douce $r'_{i,j}$ et les grandeurs d'entrée initiales $r_{i,1}$: $r''_{i,j} = \gamma_j . r'_{i,j} + \beta_j . r_{i,1}$

Par ailleurs dans l'exemple qui a été décrit, les lignes de la matrice correspondent exactement aux mots de code de Reed Solomon. Ce choix est particulièrement avantageux, mais on peut utiliser d'autres types de correspondance, en choisissant de préférence une relation simple entre les tailles des deux codes, par exemple en choisissant que l'une soit un multiple de l'autre.

Enfin, dans un autre mode de réalisation, on insère de façon connue, entre la sortie des moyens 20 de décodage itératif et l'entrée des moyens 22 de décodage de Reed Solomon, des moyens de localisation des octets qui sont potentiellement faux. A titre d'exemple, de tels moyens de localisation consistent à comparer le premier minimum MIN1, ou la valeur moyenne des informations de fiabilité, à un seuil fixe ou variable en deçà duquel une information dite information d'effacement est délivrée aux moyens 22 de décodage de Reed Solomon. Pour plus de détails, on se reportera à l'ouvrage précité "Error control techniques for digital communications".

## Revendications

1. Système de transmission numérique comportant en émission des moyens (3) de codage de données à transmettre (1), et en réception des moyens (20) de décodage itératif des données reçues (10), lesdits moyens de décodage itératif utilisant les données reçues comme grandeurs d'entrée initiales, et comportant des moyens (220) de calcul d'informations de fiabilité ($f_{i,j}$) relatives à des décisions douces ($r'_{i,j}$), à partir de grandeurs d'entrée (13, $r_{i,j}$), à chaque itération (j), et des moyens pour réinjecter des grandeurs d'entrée subséquentes ($r_{i,j+1}$) pour l'itération suivante (j+1), **caractérisé en ce que** lesdits moyens de décodage comportent :

   - des moyens de calcul à l'itération j d'une valeur moyenne de plusieurs décisions douces ($r'_{i,j}$) obtenues au cours de l'itération j,
   - des moyens de transformation (240) pour calculer des informations transformées ($t_{i,j}$) à partir desdites décisions douces, lesdites informations transformées étant obtenues en divisant lesdites décisions douces par ladite valeur moyenne,
   - et des moyens (250) d'élaboration des grandeurs d'entrée subséquentes ($r_{i,j+1}$) à partir desdites informations transformées ($t_{i,j}$).

2. Système de transmission numérique selon la revendication 1, **caractérisé en ce que** lesdits moyens (250) d'élaboration des grandeurs d'entrées subséquentes comportent des moyens (260) de pondération pour calculer des sommes pondérées ($r''_{i,j}$) desdites informations transformées ($t_{i,j}$) et des grandeurs d'entrée initiales ($r_{i,1}$), avec un premier ($\gamma_j$) et un second ($\beta_j$) coefficient de pondération respectivement.

3. Système de transmission numérique selon la revendication 2, caractérisé ce que la somme desdits premier et second coefficients de pondération est égale à un.

4. Système de transmission selon l'une des revendications 1 à 3, **caractérisé en ce que** lesdits moyens de codage comportent des premiers moyens de codage (4) à partir d'un code de Reed Solomon et des seconds moyens de codage (5) à partir d'un code multidimensionnel à parités entrelacées, lesdits moyens de décodage itératifs étant utilisés pour restituer, à partir des données reçues (10), les données codées par le code Reed Solomon.

5. Procédé de décodage itératif de données utilisant lesdites données comme grandeurs d'entrée initiales ($r_{1,i}$) et comportant à chaque itération:

   - une étape (140) de calcul d'informations de fiabilité ($f_{i,j}$) relatives à des décisions douces ($r'_{i,j}$), à partir de grandeurs d'entrée (13, $r_{i,j}$),
   - et une étape de réinjection de grandeurs d'entrée subséquentes pour l'itération suivante,

   **caractérisé en ce qu'**il comporte

   - une étape de calcul à l'itération j d'une valeur moyenne de plusieurs décisions douces ($r'_{i,j}$) obtenues au cours de l'itération j,
   - une étape de transformation (240) pour calculer des informations transformées ($t_{i,j}$) à partir desdites décisions douces, lesdites informations transformées étant obtenues en divisant lesdites décisions douces par ladite valeur moyenne,
   - et une étape (250) d'élaboration des grandeurs d'entrée subséquentes ($r_{i,j+1}$) à partir desdites informations transformées ($t_{i,j}$).

6. Procédé de décodage selon la revendication 5, **caractérisé en ce que** ladite étape (160) d'élaboration des grandeurs d'entrée subséquentes comporte une étape de pondération pour calculer des sommes pondérées ($r''_{i,j}$) desdites informations transformées et des grandeurs d'entrée initiales ($r_{i,1}$), avec un premier ($\gamma_j$) et un second ($\beta_j$) coefficient de pondération respectivement.

7. Procédé de décodage selon la revendication 6, **caractérisé en ce que** la somme desdits premier et second coefficients de pondération est égale à un.

8. Décodeur doté de moyens (20) de décodage itératif de données qui utilisent lesdites données comme grandeurs d'entrée initiales et qui comportent des moyens (220) de calcul d'informations de fiabilité ($f_{i,j}$) relatives à des décisions douces ($r'_{i,j}$) à partir de grandeurs d'entrée (13, $r_{i,j}$), à chaque itération, et des moyens pour réinjecter des grandeurs d'entrée subséquentes ($r_{i,j+1}$) pour l'itération suivante, **caractérisé en ce que** lesdits moyens de décodage comportent :

   - des moyens de calcul à l'itération j d'une valeur moyenne de plusieurs décisions douces ($r'_{i,j}$) obtenues au cours de l'itération j,
   - des moyens de transformation (240) pour calculer des informations transformées ($t_{i,j}$) à partir desdites décisions douces, lesdites informations transformées étant obtenues en divisant lesdites décisions douces par ladite valeur moyenne,
   - et des moyens (250) d'élaboration des grandeurs d'entrée subséquentes ($r_{i,j+1}$) à partir desdites informations transformées ($t_{i,j}$).

9. Décodeur selon la revendication 8, **caractérisé en ce que** lesdits moyens d'élaboration des grandeurs d'entrée à réinjecter comportent des moyens (260) de pondération pour calculer des sommes pondérées ($r''_{i,j}$) desdites informations transformées et des grandeurs d'entrée initiales, avec un premier ($\gamma_j$) et un second ($\beta_j$) coefficient de pondération respectivement.

10. Décodeur selon la revendication 9, **caractérisé en ce que** la somme desdits premier et second coefficients de pondération est égale à un.


**Patentansprüche**

1. Digitales Übertragungssystem mit beim Senden Mitteln (3) zum Kodieren der zu übertragenden Daten (1) und beim Empfangen Mitteln (20) zum iterativen Dekodieren der erhaltenen Daten (10), wobei die besagten iterativen Dekodierungsmittel die erhaltenen Daten als initiale Eingangsgrößen verwenden, Mitteln (220) zur Berechnung von Zuverlässigkeitsinformationen ($f_{i,j}$) in Bezug auf sanfte Entscheidungen ($r'_{i,j}$) anhand der Eingangsgrößen (13, $r_{i,j}$) bei jeder Iteration (j) und Mitteln, um subsequente Eingangsgrößen ($r_{i,j+1}$) für die darauffolgende Iteration (j+1) erneut einzuschieben, **dadurch gekennzeichnet, dass** die besagten Mittel zur Dekodierung enthalten:

   - Mittel zur Berechnung bei der Iteration j eines Durchschnittswertes von mehreren, im Laufe der Iteration j erhaltenen sanften Entscheidungen ($r'_{i,j}$),
   - Umwandlungsmittel (240) zur Berechnung der anhand der besagten sanften Entscheidungen umgewandelten Informationen ($t_{i,j}$), wobei die umgewandelten Informationen erhalten werden, indem die besagten sanften Entscheidungen durch den besagten Durchschnittswert geteilt werden,
   - und Mittel zur Erhebung (240) der nachfolgenden Eingangsgrößen ($r_{i,j+1}$) anhand der besagten umgewandelten Informationen ($t_{i,j}$).

2. Digitales Übertragungssystem nach Anspruch 1, **dadurch gekennzeichnet, dass** die besagten Mittel (250) zur Erhebung der nachfolgenden Eingangsgrößen Wägungsmittel (260) zur Berechnung der gewägten Summen ($r''_{i,j}$) der besagten umgewandelten Informationen ($t_{i,j}$) und der initialen Eingangsgrößen ($r_{i,1}$) mit jeweils einem ersten ($\gamma_j$) und einem zweiten ($\beta_j$) Wägungskoeffizienten enthalten.

3. Digitales Übertragungssystem nach Anspruch 2, **dadurch gekennzeichnet, dass** der erste und der zweite Wägungskoeffizient gleich eins ist.

4. Übertragungssystem nach einem der Ansprüche 1 bis 3, **dadurch gekennzeichnet, dass** die besagten Kodierungsmittel erste Kodierungsmittel (4) anhand einem Reed-Solomon-Kode und zweite Kodierungsmittel (5) anhand eines multidimensionalen Kodes mit verschlungenen Paritäten enthalten, wobei die iterativen Dekodierungsmittel verwendet werden, um anhand der erhaltenen Daten (10) die vom Reed-Solomon-Kode kodierten Daten zurückzuerhalten.

5. Iteratives Verfahren zur Dekodierung von Daten unter Verwendung der besagten Daten als initiale Eingangsdaten ($r_{i,j}$), welches bei jedem Schritt enthält:

   - einen Schritt (140) zur Berechnung der Zuverlässigkeitsinformationen ($f_{i,j}$) in Bezug auf sanfte Entscheidungen ($r'_{i,j}$) anhand von Eingangsgrößen (13, $r_{i,j}$) und
   - einen Schritt zum erneuten Einschieben von subsequenten Eingangsgrößen für die nachfolgende Iteration,

   **dadurch gekennzeichnet, dass** es enthält:

   - einen Schritt zur Berechnung bei der Iteration j eines Durchschnittswertes von mehreren sanften, im Laufe der Iteration j erhaltenen Entscheidungen ($r'_{i,j}$),
   - einen Umwandlungsschritt (240) zur Berechnung der anhand der besagten sanften Entscheidungen umgewandelten Informationen ($t_{i,j}$), wobei die umgewandelten Informationen erhalten werden, indem die besagten sanften Entscheidungen durch den besagten Durchschnittswert geteilt werden, und
   - einen Schritt (250) zur Erhebung der nachfolgenden Eingangsgrößen ($r_{i,j+1}$) anhand der besagten umgewandelten Informationen ($t_{i,j}$).

6. Dekodierungsverfahren nach Anspruch 5, **dadurch gekennzeichnet, dass** der besagte Schritt (160) zur Erhebung der subsequenten Eingangsgrößen einen Wägungsschritt zur Berechnung der gewägten Summen ($r''_{i,j}$) der besagten umgewandelten Informationen und der initialen Eingangsgrößen ($r_{i,1}$) mit jeweils einem ersten ($\gamma_j$) und einem zweiten ($\beta_j$)

Wägungskoeffizienten enthalten.

7. Dekodierungsverfahren nach Anspruch 6, **dadurch gekennzeichnet, dass** die Summe des besagten ersten und zweiten Wägungskoeffizienten gleich eins ist.

8. Dekoder mit Mitteln (20) zum iterativen Dekodieren von Daten unter Verwendung der besagten Daten als initiale Eingangsgrößen und mit Mitteln (220) zur Berechnung von Zuverlässigkeitsinformationen ($f_{i,j}$) in Bezug auf sanfte Entscheidungen ($r'_{i,j}$) anhand von Eingangsgrößen (13, $r_{i,j}$) bei jeder Iteration und Mitteln zum erneuten Einschieben der subsequenten Eingangsgrößen ($r_{i,j+1}$) für die nachfolgende Iteration,
   **dadurch gekennzeichnet, dass** die besagten Dekodierungsmittel enthalten:

   - Mittel zur Berechnung bei der Iteration j eines Durchschnittswertes von mehreren, im Laufe der Iteration j erhaltenen sanften Entscheidungen ($r'_{i,j}$),
   - Umwandlungsmittel (240) zur Berechnung der anhand der besagten sanften Entscheidungen umgewandelten Informationen ($t_{i,j}$), wobei die umgewandelten Informationen erhalten werden, indem die besagten sanften Entscheidungen durch den besagten Durchschnittswert geteilt werden,
   - und Mittel (250) zur Erhebung der nachfolgenden Eingangsgrößen ($r_{i,j+1}$) anhand der besagten umgewandelten Informationen ($t_{i,j}$).

9. Dekodierer nach Anspruch 8, **dadurch gekennzeichnet, dass** die besagten Mittel zur Erhebung der nachfolgenden Eingangsgrößen Wägungsmittel (260) zur Berechnung der gewägten Summen ($r''_{i,j}$) der besagten umgewandelten Informationen und der initialen Eingangsgrößen mit jeweils einem ersten ($\gamma_j$) und einem zweiten ($\beta_j$) Wägungskoeffizienten enthalten.

10. Dekodierer nach Anspruch 9, **dadurch gekennzeichnet, dass** die Summe des besagten ersten und zweiten Wägungskoeffizienten gleich eins ist.

## Claims

1. A digital transmission system comprising at the transmitting end transmit data (1) coding means (3), and at the receiving end iterative decoding means (20) for received data (10), said iterative decoding means using received data as initial input magnitudes, and including calculating means (220) for calculating for each iteration (j) reliability data ($f_{i,j}$) relating to soft decisions ($r'_{i,j}$) based on input magnitudes (13, $r_{i,j}$), and means for reinserting subsequent input magnitudes ($r_{i,j+1}$) for the next iteration, **characterized in that** said decoding means comprise:

- calculation means for calculating at the iteration j a mean value of various soft decisions ($r'_{i,j}$) obtained during the iteration j,
- transformation means (240) for calculating transformed data ($t_{i,j}$) from said soft decisions, said transformed data being obtained by dividing said soft decisions by said mean value,
- and subsequent input magnitude ($r_{i,j+1}$) generating means (250) based on said transformed data ($t_{i,j}$).

2. A digital transmission system as claimed in claim 1, **characterized in that** said means (250) for generating subsequent input magnitudes comprise weighting means (260) for calculating weighted sums ($r''_{i,j}$) of said transformed data ($t_{i,j}$) and of said initial input magnitudes ($r_{i,1}$) with a first ($\gamma_j$) and a second ($\beta_j$) weight factor, respectively.

3. A digital transmission system as claimed in claim 2, **characterized in that** the sum of said first and second weight factors is equal to unity.

4. A transmission system as claimed in one of the claims 1 to 3, **characterized in that** said coding means comprise first coding means (4) based on a Reed Solomon code and second coding means (5) based on a multidimensional interleaved-parity code, said iterative decoding means being used for restoring, based on the received data (10), the data coded by the Reed Solomon code.

5. An iterative data decoding method using said data as initial input magnitudes ($r_{j,i}$), and comprising for each iteration:

- a calculation step (140) for calculating, based on input magnitudes (13, $r_{i,j}$), reliability data ($f_{i,j}$) relating to soft decisions ($r'_{i,j}$)
- and a step for reinserting subsequent input magnitudes for the next iteration, **characterized in that** the method comprises
- a calculating step for calculating at the iteration j a mean value of various soft decisions ($r'_{i,j}$) obtained during the iteration j,
- a transformation step (240) for calculating transformed data ($t_{i,j}$) from soft decisions, said transformed data being obtained by dividing said soft decisions by said mean value,
- and a subsequent input magnitude ($r_{i,j+1}$) generating step (250) based on said transformed data.

6. A decoding method as claimed in claim 5, **characterized in that** said step (160) for generating subsequent input magnitudes comprises a weighting step for calculating weighted sums ($r''_{i,j}$) of said transformed data and of said initial input magnitudes ($r_{i,j}$) with a first ($\gamma_j$) and a second ($\beta_j$) weight factor, respectively.

7. A decoding method as claimed in claim 6, **characterized in that** the sum of said first and second weight factors is equal to unity

8. A decoder comprising iterative data decoding means (20), which use said data as initial input magnitudes and comprise calculating means (220) for calculating for each iteration reliability data ($f_{i,j}$) relating to soft decisions ($r'_{i,j}$) based on input magnitudes (13, $r_{i,j}$), and means for reinserting subsequent input magnitudes ($r_{i,j+1}$) for the next iteration, **characterized in that** said decoding means comprise:

- calculation means for calculating at the iteration j a mean value of various soft decisions ($r'_{i,j}$) obtained during the iteration j,
- transformation means (240) for calculating transformed data ($t_{i,j}$) from said soft decisions, said transformed data being obtained by dividing said soft decisions by said mean value,
- and subsequent input magnitude ($r_{i,j+1}$) generating means (250) based on said transformed data ($t_{i,j}$).

9. A decoder as claimed in claim 8, **characterized in that** said generating means for generating subsequent input magnitudes to be reinserted comprise weighting means (260) for calculating weighted sums ($r''_{i,j}$) of said transformed data and of said initial input magnitudes with a first ($\gamma_j$) and a second ($\beta_j$) weight factor, respectively.

10. A decoder as claimed in claim 9, **characterized in that** the sum of said first and second weight factors is equal to unity.

FIG.1

+ B : 01          + A : 00

Im

Re

+ C : 11          + D : 10

FIG. 2

FIG.3

$i = 0$ ; $MIN = \infty$

$i = 1, \ldots, n$

$bi = sgn(r_{i,j})$

$p = p \oplus bi$

$MIN1 > |r_{i,j}| \Longrightarrow MIN1 = |r_{i,j}|$

$iMIN1 = i$

— 110

$b_{iMIN1} = b_{iMIN1} \oplus p$

$inv = 1 - 2p$

— 120

$j = 1, \ldots, N$

$j = N$ ? — 125

— 126

$MIN2 = \infty$

$i = 1, \ldots, n \quad i \neq iMIN1$

$MIN2 > |r_{i,j}| \Longrightarrow MIN2 = |r_{i,j}|$

— 130

$i = 1, \ldots, n \quad i \neq iMIN1$

$f_{i,j} = [|r_{i,j}| + inv. MIN1]$

$i = iMIN1 \Longrightarrow f iMIN1, j = MIN2 + inv.MIN1$

$i = 1, \ldots, n \Longrightarrow r'_{i,j} = (1-2b_i) \cdot f_{i,j}$

— 140

$\mu = \dfrac{1}{n} \displaystyle\sum_{i=1}^{n} |r'_{i,j}|$

— 150

$i = 1, \ldots, n$

$t_{i,j} = r'_{i,j} / \mu$

$r''_{i,j} = \gamma j . t_{i,j} + \beta j . r_{i,1}$

$r_{i,j+1} = r''_{i,j} \Longrightarrow ⑫$

— 160

170 — $b_{i,N}$

11

EP 0 917 294 B1

$r_{i,j+1}$

12

210

220

240

250

260

270

22

P
MIN 1
$b_i$

$b_i$ MIN1
inv

MIN 2
$f_{i,j}$
$r'_{i,j}$

$t_{i,j}$

$r''_{i,j}$

$b_{i,N}$

$b_{i,j} \neq N$

FIG.4

FIG.5A

FIG.5B

EP 0 917 294 B1

PDF($r_{i,1}$)

−1    +1    $r_{i,1}$

FIG. 6A

PDF($r_{i,4}$)

−1    +1    $r_{i,4}$

FIG. 6B